# EUROPEAN PATENT APPLICATION

(11) **EP 2 182 564 A1**
(43) Date of publication of application: **05.05.2010**
(21) Application number: 09174344.3
(22) Date of filing: 28.10.2009
(51) Int. Cl.: H01L 51/52

(54) **Organic light emitting display device**

(30) Priority: 29.10.2008 KR 20080106359
(71) Applicant: Samsung Mobile Display Co., Ltd., Yongin-City Gyunggi-do (KR)
(72) Inventor: Seo, Chang-Su, Chungcheongnam-do (KR); Kim, Tae-Gon, Chungcheongnam-do (KR); Koh, Sung-Soo, Chungcheongnam-do (KR); Jeon, Hee-Chul, Chungcheongnam-do (KR); Han, Byung-Uk, Chungcheongnam-do (KR)
(74) Representative: Gulde Hengelhaupt Ziebig & Schneider

(57) **Abstract**

Embodiments of the present invention provide an organic light emitting display device including: a plurality of light emitting elements on a first substrate (100), each of the plurality of light emitting elements including a first electrode (131) and an organic light emitting layer (133), and a second electrode (134) on the plurality of light emitting elements; a second substrate (300) facing the first substrate with the plurality of light emitting elements therebetween; spacers (320) on the second substrate corresponding to portions of the second electrode, the portions located on spaces between the plurality of light emitting elements; and an auxiliary electrode (340) on the spacers and contacting the second electrode.

## Description

### BACKGROUND OF THE INVENTION

### 1. Field of the Invention

The present invention relates to an organic light emitting display device having a front emitting structure, and more particularly to an organic light emitting display device having a cathode electrode shared by a plurality of light emitting devices in a display region.

### 2. Description of Related Art

An organic light emitting display device, which is a display device having self-light emitting characteristics, includes a substrate arranged with light emitting elements each including an organic light emitting layer, a sealing substrate disposed to facing the substrate, and a sealant sealing the light emitting elements between the substrate and the sealing substrate.

The organic light emitting display device constituted as above is classified as a front emitting structure or a rear emitting structure according to the direction that light is emitted from the organic light emitting layer. The front emitting structure in which light is emitted in the direction of the sealing substrate has a larger aperture than that of the rear emitting structure in which light is emitted in the direction of the substrate on which the light emitting elements are arranged.

The organic light emitting display device having the front emitting structure emits light in the direction of the sealing substrate so that a cathode electrode should be formed of a thin transparent electrode material such as indium tin oxide (ITO), indium zinc oxide (IZO) or the like. However, since the transparent electrode material has high resistivity, when the cathode electrode is formed as a common electrode over the display region, a voltage difference occurs between different locations across the cathode electrode, causing a problem that picture quality is not uniform. In other words, difference in brightness occurs due to the voltage difference between a position close to the power supply source and a position far from the power supply source, thereby causing deterioration in the picture quality. The voltage difference increases as the size of the organic light emitting display device operated in a current driving manner is increased. The driving voltage can be increased in order to decrease the voltage difference. However, increasing the driving voltage causes an increase in power consumption. Therefore, in order to implement a large display device, there is demand for studies on material and a structure of the cathode electrode capable of implementing high definition without increasing power consumption.

### SUMMARY OF THE INVENTION

It is an aspect of the present invention to provide an organic light emitting display device capable of minimizing or reducing a voltage difference between different locations on a cathode electrode.

It is another aspect of the present invention to provide an organic light emitting display device in which a cathode electrode can stably contact an auxiliary electrode for compensating for a voltage drop across the cathode electrode.

According to a first embodiment of the present invention, there is provided an organic light emitting display device including: a first substrate; a plurality of light emitting elements on the first substrate, each of the plurality of light emitting elements including a second electrode and an organic light emitting layer, and a first electrode on the plurality of light emitting elements; a second substrate facing the first substrate with the plurality of light emitting elements therebetween; spacers on the second substrate corresponding to portions of the first electrode, the portions located on spaces between the plurality of light emitting elements; and an auxiliary electrode on the spacers which contacts the first electrode.

The first electrode may be a common electrode of the plurality of light emitting elements. The auxiliary electrode may comprise a plurality of electrodes electrically connected in a mesh shape or in a stripe shape. The auxiliary electrode is preferably formed of a conductive material or metal having lower resistivity than that of the first electrode. The metal may be selected from the group consisting of Al, Mo, Cr, Pt, W, Cu, Ag, Au and combinations thereof. The conductive material may be selected from the group consisting of Cr, Cr₂O₃, and MIHL. The spacers may be formed of an organic material or an inorganic material. The organic light emitting display device may further comprise a thin film transistor connected to the second electrode of a corresponding one of the light emitting elements.

According to another embodiment of the present invention, an organic light emitting display device includes: a first substrate having a plurality of light emitting elements; a common electrode on the plurality of light emitting elements; a second substrate facing the first substrate with the plurality of light emitting elements therebetween; and an auxiliary electrode substantially evenly distributed on non-light emitting regions of the common electrode.

The auxiliary electrode may comprise a plurality of electrodes electrically connected in a mesh shape or in a stripe shape. The auxiliary electrode preferably comprises a conductive material or metal having lower resistivity than that of the common electrode.

With the organic light emitting display device according to the embodiments of the present invention, the spacers and the auxiliary electrode in a stacked structure may be formed on the sealing substrate, and the auxiliary electrode may be closely adhered to the cathode electrode by the spacers. The voltage across the cathode electrode may be substantially constantly maintained by the auxiliary electrode having lower resistance than that of the cathode electrode irrespective of its location, such that power consumption may be decreased, and difference in brightness between pixels may be reduced. The auxiliary electrode may contact the cathode electrode stably by using the spacers, making it possible to implement high definition picture quality. Also, the auxiliary electrode of the embodiments of the present invention may be formed of metal having low transmittance to function as a black matrix for suppressing reflection of external light, thereby decreasing black brightness and improving contrast. Therefore, a separate black matrix or polarizing plate may not be required, thereby simplifying the structure of a display device.

### BRIEF DESCRIPTION OF THE DRAWINGS

These and/or other aspects of the present invention will become apparent and more readily appreciated from the following description of the exemplary embodiments, taken in conjunction with the accompanying drawings of which:
FIG. 1 is a schematic drawing illustrating a plan view of an organic light emitting display device according to an embodiment of the present invention;
FIG. 2 is a schematic drawing illustrating a cross-sectional view of a light emitting element of the organic light emitting display device of FIG. 1;
FIG. 3 is a schematic drawing illustrating an enlarged plan view of a portion of a sealing substrate for sealing a display region on which a plurality of light emitting elements are formed;
FIG. 4 is a schematic drawing illustrating a cross-sectional view taken along the line I1-I2 of FIG. 3;
FIG. 5 is a schematic drawing illustrating a cross-sectional view of an organic light emitting display device according to an embodiment of the present invention; and
FIG. 6 is a schematic drawing illustrating an enlarged cross-sectional view of portion "B" of FIG. 5.

### DETAILED DESCRIPTION OF EXEMPLARY EMBODIMENTS

In the following detailed description, only certain exemplary embodiments of the present invention have been shown and described, simply by way of illustration. As those skilled in the art would realize, the described embodiments may be modified in various different ways, all without departing from the scope of the present invention. Accordingly, the drawings and description are to be regarded as illustrative in nature and not restrictive. In addition, when an element is referred to as being "on" another element, it can be directly on another element or be indirectly on another element with one or more intervening elements interposed therebetween. Also, when an element is referred to as being "connected to" another element, it can be directly connected to another element or be indirectly connected to another element with one or more intervening elements interposed therebetween. Hereinafter, like reference numerals refer to like elements.

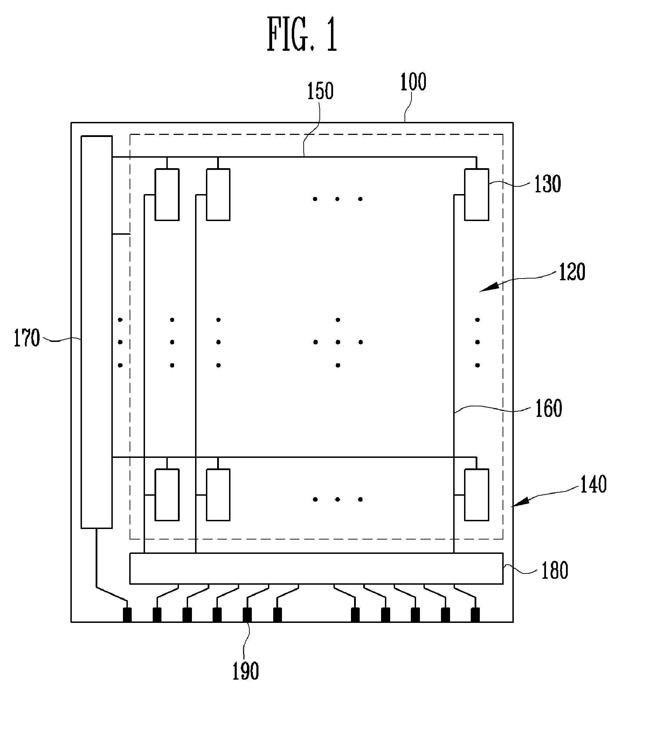

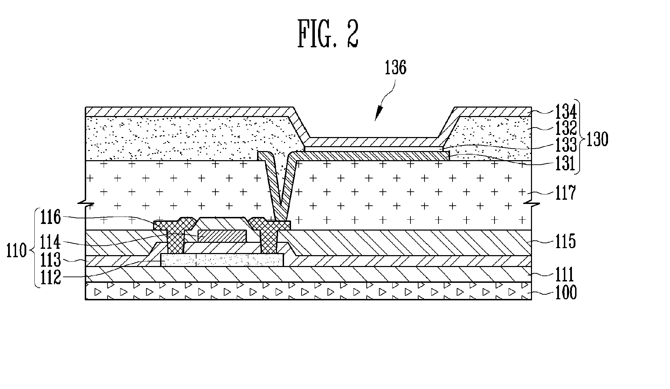

FIG. 1 is a schematic drawing illustrating a plan view of an organic light emitting display device according to an embodiment of the present invention, and FIG. 2 is a schematic drawing illustrating a cross-sectional view of a light emitting element of the organic light emitting display device of FIG. 1.

Referring to FIG. 1, a substrate 100 includes a display region 120 and a non-display region 140 located around the display region 120. Scan lines 150 and data lines 160 extend on the substrate 100, and a plurality of light emitting elements 130 arranged in a matrix form in the display region 120 are connected between the scan lines 150 and the data lines 160. The scan lines 150 and the data lines 160 extend from the non-display region 140 to the display region 120. Power supply lines (not shown) supply power to operate the light emitting elements 130, and a scan driver 170 and a data driver 180 are provided to process signals provided from the outside through a pad 190 and supply them to the scan lines 150 and data lines 160. The scan driver 170 and the data driver 180 each include driving circuits for converting signals provided from the outside into scan signals and data signals, respectively, to drive the light emitting elements 130 selectively.

Referring to FIG. 2, each of the light emitting elements 130 includes an anode electrode 131, a cathode electrode 134 and an organic light emitting layer 133 between the anode electrode 131 and the cathode electrode 134. A plurality of the anode electrodes 131 are formed on the substrate 100. The organic light emitting layer 133, which is formed on a light emitting region (a region on which the anode electrode is exposed) defined by a pixel defining film 132, may include a hole injection layer, a hole transporting layer, an electron transporting layer and an electron injection layer. Also, the cathode electrode 134 is disposed over the display region 120 to be used as a common electrode of the plurality of light emitting devices 130.

Also, the light emitting element 130 is coupled to a thin film transistor 110 for controlling the operation of the light emitting element 130, and a capacitor (not shown) is coupled to the thin film transistor 110 for maintaining a signal (e.g., a gate voltage). The thin film transistor 110 includes a semiconductor layer 112, a gate electrode 114 and source/drain electrodes 116. The semiconductor layer 112 provides a source and drain region and a channel region. The gate electrode 114 is insulated from the semiconductor layer 112 by a gate insulating layer 113. Also, the source/drain electrodes 116 are connected to the semiconductor layer 112 at the source and drain regions through contact holes formed in the insulating layer 115 and the gate insulating layer 113. Further, a buffer layer 111 is located on the substrate 100, and another insulating layer 117 is located on the insulating layer 115.

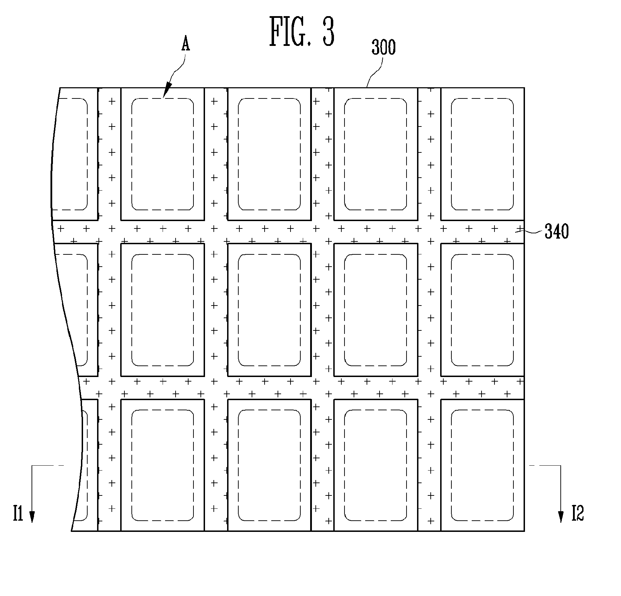

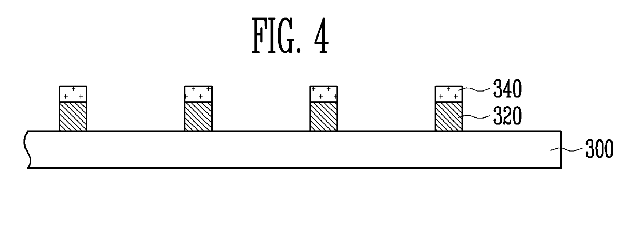

FIG. 3 is a schematic drawing illustrating an enlarged plan view of a portion of the sealing substrate 300 for sealing the display region 120 on which a plurality of light emitting elements 130 are formed, and FIG. 4 is a schematic drawing illustrating a cross-sectional view taken along the line 11-12 of FIG. 3.

Referring to FIGS. 3 and 4, spacers 320 and an auxiliary electrode 340 are formed in a stacked structure on the sealing substrate 300 so as to correspond to the cathode electrode 134, and are located between the plurality of light emitting elements 130. The auxiliary electrode 340 may also be described as a plurality of electrically interconnected electrodes. For example, the auxiliary electrode 340 is shown as a plurality of electrodes connected in a mesh shape. The "A" portion of FIG. 3 shown using dotted lines is a portion corresponding to a light emitting region 136 (shown in FIG. 2) so as to show a portion corresponding to the cathode electrode 134 between the plurality of light emitting elements 130.

The spacers 320 are formed so as to maintain a spacing between the light emitting elements 130 and the sealing substrate 300, and to closely adhere the auxiliary electrode 340 to the cathode electrode 134. Thereby, the heights of the spacers 320 may be controlled by the spacing between the light emitting elements 130 and the sealing substrate 300 and the thickness of the auxiliary electrode 340. The spacers 320 may be formed of an organic material or inorganic material. Also, the auxiliary electrode 340 is formed so as to contact the cathode electrode 134 to decrease its resistivity, and at the same time, to decrease voltage difference between locations across the cathode electrode 134 through the evenly distributed contact parts formed by the auxiliary electrode 340. Further, the auxiliary electrode 340 is formed of a conductive material or metal having lower resistivity than that of the cathode electrode 134. For example, when the cathode electrode 134 is formed of ITO, IZO or the like, the auxiliary electrode 340 may be formed of metal having lower resistivity, for example, Al, Mo, Cr, Pt, W, Cu, Ag, Au or the like.

FIG. 3 shows an embodiment where the spacers 320 and the auxiliary electrode 340 are formed in a mesh shape, but they may also be formed in a stripe shape where the contact parts of the auxiliary electrode 340 and the cathode electrode 134 are evenly distributed and electrically connected.

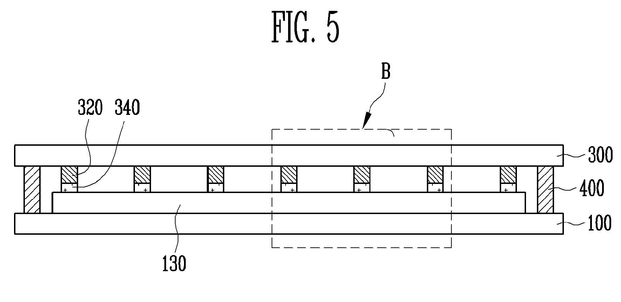

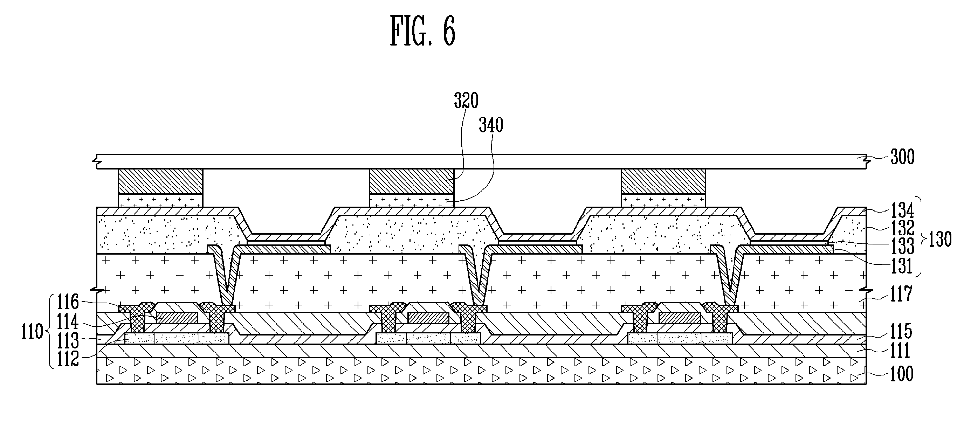

FIG. 5 is a schematic drawing illustrating a cross-sectional view of an organic light emitting display device according to an embodiment of the present invention, and FIG. 6 is a schematic drawing illustrating an enlarged cross-sectional view of portion "B" of FIG. 5.

Referring to FIGS. 5 and 6, the sealing substrate 300 for sealing the display region 120 is disposed on the top of the substrate 100 including the plurality of light emitting elements 130, and the sealing substrate 300 is bonded or attached to the substrate 100 by a suitable sealant 400. As the sealing substrate 300 is bonded to the substrate 100, the auxiliary electrode 340 of the sealing substrate 300 contacts the cathode electrode 134. The contact parts of the auxiliary electrodes 340 and the cathode electrode 134 can be maintained stably by the spacers 320.

In another embodiment of the present invention, the auxiliary electrode 340 may be formed of metal having low transmittance such as chrome (Cr), an oxide including metal having such low transmittance (for example, Cr₂O₃ or the like) or a conductive material having an inverse proportion of inorganic material and metal according to a thickness, such as metal insulator hybrid layer (MIHL) or the like. Therefore, the auxiliary electrode 340 can function as a black matrix for suppressing reflection of external light, thereby decreasing black brightness and improving contrast. In this case, a separate black matrix or polarizing plate is not required, thereby simplifying a structure of a display device. In order words, the auxiliary electrode 340 may be formed on the non-light emitting regions of the cathode electrode 134.

Also, if spacers (not shown) are formed on the pixel defining film 132 corresponding to the spacers 320 in the structure shown in FIG. 6, the contacts between the auxiliary electrode 340 and the cathode electrode 134 can be maintained more stably.

## Claims

1. An organic light emitting display device comprising:
a first substrate (100);
a plurality of light emitting elements (130) on the first substrate (100) and a first electrode (134) on the plurality of light emitting elements (130);
a second substrate (300) facing the first substrate (100) with the plurality of light emitting elements (130) therebetween; and
an auxiliary electrode (340).

2. The organic light emitting display device according to claim 1, wherein each of the plurality of light emitting elements (130) comprises a second electrode (131) and an organic light emitting layer (133).

3. The organic light emitting display device according to any one of the preceding claims, further comprising spacers (320) on the second substrate (300) corresponding to portions of the first electrode (134), the portions located on spaces between the plurality of light emitting elements (130).

4. The organic light emitting display device according to any one of the preceding claims, wherein the auxiliary electrode (340) is located on the spacers (320) and contacts the first electrode (134).

5. The organic light emitting display device according to any one of the preceding claims, wherein the first electrode (134) is a common electrode of the plurality of light emitting elements (130).

6. The organic light emitting display device according to any one of the preceding claims, wherein the auxiliary electrode (340) comprises a plurality of electrodes electrically connected in a mesh shape or in a stripe shape.

7. The organic light emitting display device according to any one of the preceding claims, wherein the auxiliary electrode (340) is formed of a conductive material or metal having lower resistivity than that of the first electrode (134).

8. The organic light emitting display device according to claim 7, wherein the metal is selected from the group consisting of Al, Mo, Cr, Pt, W, Cu, Ag, Au and combinations thereof.

9. The organic light emitting display device according to claim 7, wherein the conductive material is selected from the group consisting of Cr, Cr₂O₃, and MIHL.

10. The organic light emitting display device according to any one of the preceding claims, wherein the spacers (320) are formed of an organic material or an inorganic material.

11. The organic light emitting display device according to any one of the preceding claims, further comprising:
a thin film transistor (110) connected to the second electrode (131) of a corresponding one of the light emitting elements (130).

12. The organic light emitting display device according to any one of the preceding claims, wherein the auxiliary electrode (340) is substantially evenly distributed on non-light emitting regions of the first electrode (134).

13. A method of manufacturing an organic light emitting display device, the method comprising the steps of
providing a first substrate (100);
forming a plurality of light emitting elements (130) on the first substrate (100);
forming a first electrode (134) on the plurality of light emitting elements (130);
providing a second substrate (300) facing the first substrate (100) with the plurality of light emitting elements (130) therebetween;
forming spacers (320) on the second substrate (300) corresponding to portions of the first electrode (134), the portions located on spaces between the plurality of light emitting elements (130); and
forming an auxiliary electrode (340) on the spacers (320) to contact the first electrode (134).

14. The method according to claim 13, wherein the step of forming a plurality of light emitting elements (130) on the first substrate (100) comprises, for each of the plurality of light emitting elements (130), the steps of
forming a second electrode (131); and
forming an organic light emitting layer (133).

15. The method according to any one of claims 13 or 14, further comprising the step of
forming a thin film transistor (110) connected to the second electrode (131) of a corresponding one of the light emitting elements (130).
